# EUROPEAN PATENT APPLICATION

(11) **EP 2 187 460 A1**
(43) Date of publication of application: **19.05.2010**
(21) Application number: 08791720.9
(22) Date of filing: 22.07.2008
(51) Int. Cl.: H01L 35/32, H01L 35/34

(54) **THERMOELECTRIC CONVERSION ELEMENT AND METHOD FOR MANUFACTURING THE SAME**

(30) Priority: 26.07.2007 JP 2007195109
(71) Applicant: Sumitomo Chemical Company, Limited, Tokyo 104-8260 (JP)
(72) Inventor: HIROYAMA, Yuichi, Tsukuba-shi Ibaraki 300-2617 (JP)
(74) Representative: Hart-Davis, Jason
(86) International application number: PCT/JP2008/063484
(87) International publication number: WO 2009/014243

(57) **Abstract**

The present invention provides thermoelectric conversion devices and production methods thereof. The thermoelectric conversion device includes: a thermoelectric conversion device main body having a ridge portion and/or a vertex portion at which a ridge and/or a vertex have/has been subjected to a chamfering process; and a film covering a surface of the thermoelectric conversion device main body, including the ridge portion and/or the vertex portion thereof.

## Description

### TECHNICAL FIELD

The present invention relates to thermoelectric conversion devices and production methods thereof.

### BACKGROUND ART

As thermoelectric conversion devices, a p-type thermoelectric conversion device made of a material such as Ca₃CO₄O₉, NaₓCoO₂, CoSb₃ or BiTeSb and an n-type thermoelectric conversion device made of a material such as SrTiO₃, BaTiO₃, Mg₂Si or CaB₆ have conventionally been known. Further, such thermoelectric conversion devices are often used at high temperature in an atmosphere such as air.

Thermoelectric conversion characteristics of some thermoelectric conversion devices are degraded when subjected to high temperature.

Therefore, an attempt has been made to cover the surface of a thermoelectric conversion device main body by a film of glass or the like (JP 11-251647).

### DISCLOSURE OF THE INVENTION

However, even with the foregoing method, it has been difficult to sufficiently maintain the characteristics of a thermoelectric conversion device. The present invention has been made in view of the above-described problems, and its object is to provide thermoelectric conversion devices and production methods thereof, which are capable of reducing the degradation of characteristics in a high temperature environment.

After having conducted studies, the present inventor et al. found that: a thermoelectric conversion device main body has a ridge and a vertex, but it is difficult for a film to be sufficiently formed at this ridge or vertex; and the diffusion of an atmospheric gas from an outside atmosphere to a thermoelectric conversion device is likely to occur via the insufficient film at this ridge or vertex, which causes the degradation of the thermoelectric conversion device, and thus reached the concept of the present invention.

A first thermoelectric conversion device according to the present invention is a thermoelectric conversion device including: a thermoelectric conversion device main body having a ridge portion and/or a vertex portion at which a ridge and/or a vertex have/has been subjected to a chamfering process; and a film covering a surface of the thermoelectric conversion device main body, including the ridge portion and/or the vertex portion thereof.

Further, a second thermoelectric conversion device according to the present invention is a thermoelectric conversion device including: a thermoelectric conversion device main body having a ridge at which two faces meet, and having an angle created by the two faces at the ridge in a cross section taken perpendicularly to the ridge, the angle being an obtuse angle; and a film covering a surface of the thermoelectric conversion device main body, including the ridge.

The first thermoelectric conversion device has the ridge portion and/or vertex portion at which the ridge and/or vertex have/has been subjected to a chamfering process. Accordingly, the film at the ridge portion and/or vertex portion can be easily formed to a thickness similar to that of the other portion.

The second thermoelectric conversion device has an obtuse angle at the ridge, and therefore, the film at the ridge can be easily formed to a thickness similar to that of the other portion.

Thus, even if an atmospheric gas, for example, is an oxidizing gas such as air in a high temperature atmosphere, by which the thermoelectric conversion device main body is likely to oxidize, the diffusion of the atmospheric gas is reduced due to the sufficient formation of the film, thereby enabling the reduction of characteristic degradation in the thermoelectric conversion device.

In this aspect, the film of the thermoelectric conversion device is preferably an oxidation preventing film. Thus, even when subjected to high temperature in an oxidizing atmosphere such as air, the characteristics of the thermoelectric conversion device can be sufficiently maintained, thereby providing the thermoelectric conversion device having high general versatility.

A main material for the film of the thermoelectric conversion device is preferably at least one of silica, alumina and silicon carbide. Thus, the thermoelectric conversion device having excellent oxidation resistance, heat resistance and abrasion resistance can be provided.

The film of the thermoelectric conversion device preferably has a thickness of 0.01µm to 1mm, more preferably has a thickness of 0.1µm to 300µm, and even more preferably has a thickness of 1µm to 100µm. If the thickness of the film falls within the foregoing ranges, the diffusion of gas via the film during use at high temperature can be sufficiently reduced. Whereas if the thickness of the film is too small, there is a tendency to make it difficult to reduce the diffusion of gas, and if the thickness is too large, there is a tendency to facilitate occurrence of cracks in the film. Besides, the more uniform the thickness of the film, the better.

A first method for producing a thermoelectric conversion device according to the present invention includes the steps of: performing a chamfering process on a ridge and/or a vertex of a thermoelectric conversion device main body; and forming a film on a surface of the thermoelectric conversion device main body, including a ridge portion and/or a vertex portion on which the chamfering process has been performed.

A second method for producing a thermoelectric conversion device according to the present invention includes the steps of: preparing a thermoelectric conversion device main body having a ridge at which two faces meet, and having an angle created by the two faces at the ridge in a cross section taken perpendicularly to the ridge, the angle being an obtuse angle; and forming a film on a surface of the thermoelectric conversion device, including the ridge.

### BRIEF DESCRIPTION OF THE DRAWINGS

FIG. 1 shows a perspective view (a) of one example of a thermoelectric conversion device according to a first embodiment, and a partial cross-sectional view (b) taken perpendicularly to a ridge E along a dotted line IIb-IIb of the thermoelectric conversion device 10.
FIG. 2 shows a perspective view of one example of a conventional thermoelectric conversion device main body.
FIG. 3 shows a perspective view (a) of another example of a thermoelectric conversion device according to the first embodiment, a partial cross-sectional view (b) taken perpendicularly to the axial direction of a ridge portion H along a dotted line IIIb-IIIb of the thermoelectric conversion device 10, and a partial cross-sectional view (c) taken perpendicularly to a ridge F along a dotted line IIIc-IIIc of the thermoelectric conversion device 10.
FIG. 4 shows a perspective view (a) of still another example of a thermoelectric conversion device according to the first embodiment, and a partial cross-sectional view (b) taken perpendicularly to a ridge K along a dotted line IVb-IVb of the thermoelectric conversion device 10.
FIG. 5 shows a perspective view (a) of one example of a thermoelectric conversion device according to a second embodiment, and a partial cross-sectional view (b) taken perpendicularly to a ridge Q along a dotted line Vb-Vb of the thermoelectric conversion device 10.
FIG. 6 shows a perspective view (a) of another example of a thermoelectric conversion device according to the second embodiment, a partial cross-sectional view (b) taken perpendicularly to the axial direction of a ridge portion N along a dotted line VIb-VIb of the thermoelectric conversion device 10, and a partial cross-sectional view (c) taken perpendicularly to a ridge S along a dotted line VIc-VIc of the thermoelectric conversion device 10.
FIG. 7 shows a perspective view (a) of still another example of a thermoelectric conversion device according to the second embodiment, and a partial cross-sectional view (b) taken perpendicularly to a ridge U along a dotted line VIIb-VIIb of the thermoelectric conversion device 10.
FIG. 8 shows one example of a thermoelectric conversion module.
FIG. 9 shows resistance values of thermoelectric conversion devices according to Examples 1 to 4 prior to and subsequent to heat application in the air, and resistance values of the thermoelectric conversion device according to Example 1 prior to and subsequent to heat application in an inert atmosphere.
FIG. 10 shows resistance values of thermoelectric conversion devices according to Comparative Examples 1 to 6 prior to and subsequent to heat application in the air.

### DESCRIPTION OF THE REFERENCE SYMBOLS

- 10: thermoelectric conversion device
- 1: thermoelectric conversion device main body
- 8: film
- 1s: exposed portion
- A, I, T: vertex
- G, M: vertex portion
- B, E, F, J, K, Q, R, S, U: ridge
- H, N: ridge portion
- a, b, c, d, e, f: plane
- g, h, I: curved surface
- Z: tangent
- 20: thermoelectric conversion module
- 15: substrate
- 3: p-type thermoelectric conversion device
- 4: n-type thermoelectric conversion device
- 5: electrode
- 6, 7: input/output electrodes

### MODE FOR CARRYING OUT THE INVENTION

Hereinafter, preferred embodiments of the present invention will be illustrated in detail with reference to the appended drawings. In the description made with reference to the drawings, the same or equivalent elements are identified by the same reference characters, and redundant description thereof are not shown. Furthermore, dimensional ratios in the respective drawings are not necessarily identical to actual dimensional ratios.

### First Embodiment

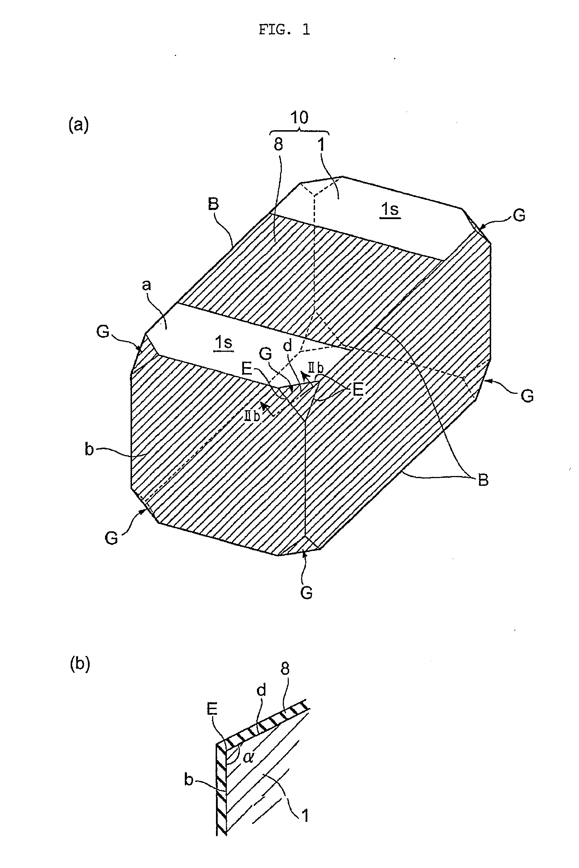

FIG. 1(a) illustrates a perspective view of one example of a thermoelectric conversion device according to a first embodiment of the present invention. The thermoelectric conversion device 10 has vertex portions G, and is almost in the shape of rectangular parallelepiped. The thermoelectric conversion device 10 includes a thermoelectric conversion device main body 1, and a film 8 that covers surfaces of the thermoelectric conversion device main body 1. Among the surfaces of the thermoelectric conversion device main body 1, one plane a (an upper face in FIG. 1(a)) including the longest ridges B has an exposed portion 1s, at which the thermoelectric conversion device main body 1 is exposed, in respective given ranges from both longitudinal ends of this plane. When the thermoelectric conversion device 10 constitutes a thermoelectric conversion module, this exposed portion 1s is formed as an electrode connection portion for connecting a plurality of the thermoelectric conversion devices 10 in series.

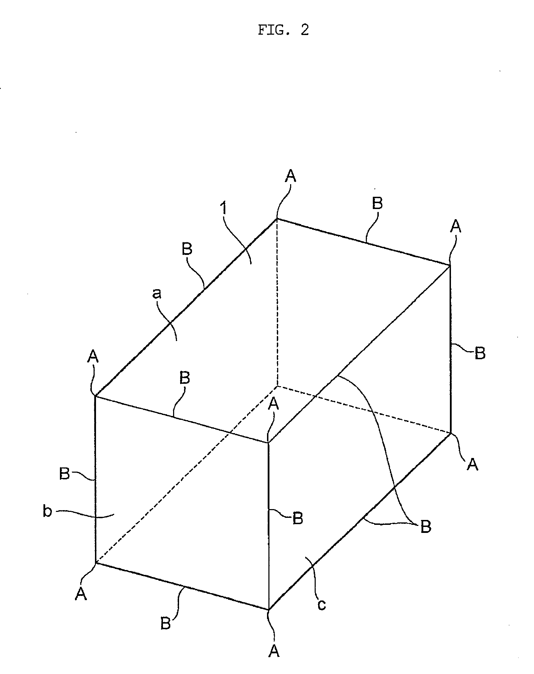

FIG. 2 illustrates a perspective view of one example of a conventional thermoelectric conversion device main body. The thermoelectric conversion device main body 1 is formed into a rectangular parallelepiped having a plurality of ridges B, and each vertex A is formed at a portion where the three ridges B meet.

The vertex portions G of the thermoelectric conversion device 10 in FIG. 1(a) are in a state where each vertex A of the thermoelectric conversion device main body 1 in FIG. 2 is C-chamfered, i.e., in a state where each vertex is chamfered by a plane d. The vertex portions G in the C-chamfered state each form the plane d surrounded by three ridges E.

In FIG. 1(b), there is illustrated a partial cross-sectional view taken perpendicularly to the ridge E along a dotted line IIb-IIb of the thermoelectric conversion device 10. In a cross section taken perpendicularly to the ridge E, an angle α created by the two faces b and d, which form the ridge E, becomes an obtuse angle greater than 90° by C-chamfering. The angle α is preferably not less than 135°, and is more preferably not less than 157°. If the angle α is not more than 90° at this ridge E, the film 8 is not formed on the ridge E to a thickness equal to that of a plane portion around the ridge E.

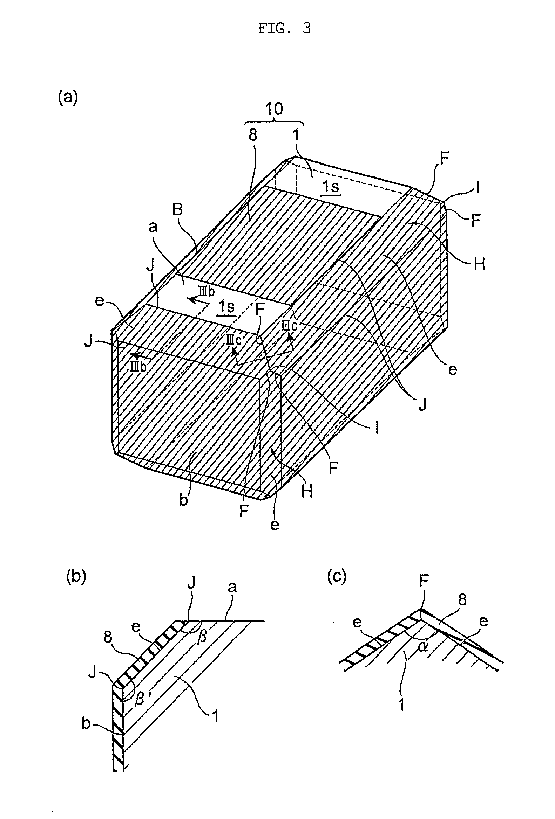

FIG. 3(a) illustrates a perspective view of another example of a thermoelectric conversion device according to the first embodiment of the present invention. The thermoelectric conversion device 10 have C-chamfered ridge portions H, and is almost in the shape of rectangular parallelepiped. The ridge portions H of the thermoelectric conversion device 10 in FIG. 3(a) are in a state where each ridge B of the thermoelectric conversion device 10 in FIG. 2 is C-chamfered by a plane e. Instead of each vertex A, a new vertex I is formed at a point where the three ridge portions H meet. Around each vertex I, a ridge F is formed as a line along which the ridge portions H meet. The ridge portions H form the planes e each surrounded by: two ridges J parallel to the original ridge B, and the four ridges F.

In FIG. 3(b), there is illustrated a partial cross-sectional view taken perpendicularly to the axial direction of the ridge portion H along a dotted line IIIb-IIIb of the thermoelectric conversion device 10. In a cross section taken perpendicularly to the ridges J, angles β and β each created by the two planes, which form the ridge J, become obtuse angles greater than 90° by chamfering. The angles β and β' are each preferably similar to the angle α. If the angles β and β' are not more than 90°, the film 8 is not formed on the ridges J to a thickness equal to that of a plane portion around the ridges J.

In FIG. 3(c), there is illustrated a partial cross-sectional view taken perpendicularly to the ridge F along a dotted line IIIc-IIIc of the thermoelectric conversion device 10. In a cross section taken perpendicularly to the ridge F, an angle α created by the two faces, which form the ridge F, becomes an obtuse angle greater than 90° by chamfering.

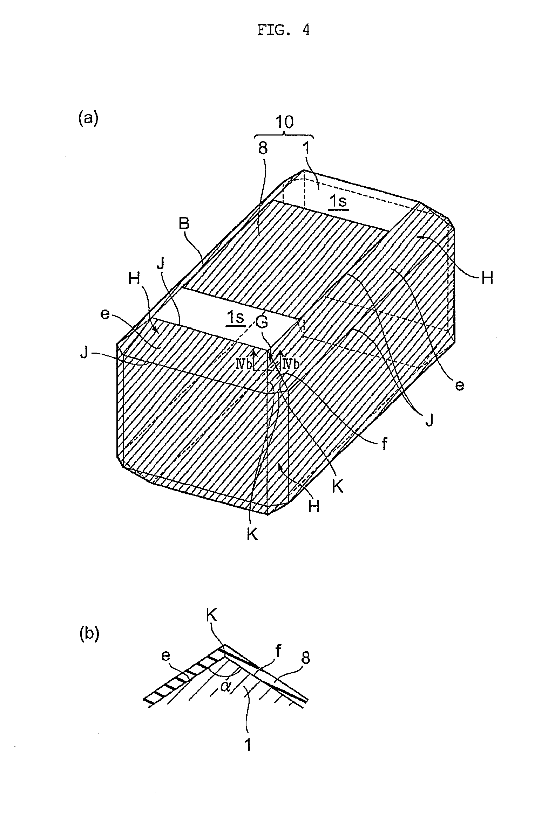

FIG. 4 (a) illustrates a perspective view of still another example of a thermoelectric conversion device according to the first embodiment of the present invention. The thermoelectric conversion device 10 has vertex portions G and ridge portions H, and is usually formed into a rectangular parallelepiped. The thermoelectric conversion device in FIG. 4(a) is in a state where each vertex I of the thermoelectric conversion device 10 in FIG. 3 is further C-chamfered by a plane f, and the plane f of the vertex portion G becomes a plane surrounded by ridges K.

In FIG. 4(b), there is illustrated a partial cross-sectional view taken perpendicularly to the ridge K along a dotted line IVb-IVb of the thermoelectric conversion device 10. In a cross section taken perpendicularly to the ridge K, an angle α created by two faces e and f, which form the ridge K, becomes an obtuse angle greater than 90° by chamfering.

Examples of p-type thermoelectric device materials for the foregoing thermoelectric conversion device main body 1 include metal composite oxides such as Ca₃Co₄O₉ and NaₓCoO₂; silicides such as MnSi_{1.73,} Fe₁₋ₓMnₓSi₂, Si_{0.8}Ge_{0.2} and β-FeSi₂; skutterudites such as CoSb₃, FeSb₃ and RFe₃CoSb₁₂ (where R represents La, Ce or Yb); and Te-containing alloys such as BiTeSb, PbTeSb, Bi₂Te₃ and PbTe. Furthermore, examples of n-type thermoelectric device materials include metal composite oxides such as SrTiO₃, Zn₁₋ₓAlₓO, CaMnO₃, LaNiO₃, BaₓTi₈O₁₆, BaTiO₃ and Ti₁₋ₓNbₓO; silicides such as Mg₂Si, Fe₁₋ₓCoₓSi₂, Si_{0.8}Ge₀.₂ and β-FeSi₂; skutterudites; clathrate compounds such as Ba₈Al₁₂Si₃₀ and Ba₈Al₁₂Ge₃₀; boron compounds such as CaB₆, SrB₆, BaB₆ and CeB₆; and Te-containing alloys such as BiTeSb, PbTeSb, Bi₂Te₃ and PbTe.

In particular, the present embodiment provides the thermoelectric conversion device 10 including the film 8; therefore, for the thermoelectric conversion device main body 1, a material whose characteristics are likely to degrade due to oxidation in an oxidizing atmosphere or reduction in a non-oxidizing atmosphere within a high temperature environment can be suitably used. Examples of such materials include Zn₄Sb₃, CoSb₃, Bi₂Te₃ and PbTe as materials for a p-type thermoelectric conversion device, and include SrTiO₃, Zn₁₋ₓAlₓO, BaTiO₃, Bi₂Te₃ and PbTe as materials for an n-type thermoelectric device.

The film 8 is preferably a film including, as a main material, one of silica, alumina and silicon carbide singly or a combination with another or more. Further, the thickness of the film 8 is preferably from 0.01µm to 1mm, more preferably from 0.1µm to 300µm, and even more preferably from 1µm to 100µm. If the thickness of the film 8 is too small, there is a tendency to make it difficult to reduce the diffusion of gas when the thermoelectric conversion device 10 is subjected to high temperature. On the other hand, if the upper limit of the thickness is too large, it becomes impossible to withstand thermal stress and the like since the film 8 is too thick, and there is a tendency to facilitate the occurrence of cracks.

In the foregoing thermoelectric conversion device, the thermoelectric device main body 1 has the ridge portions H and/or vertex portions G at which the ridges B and/or vertexes A have been subjected to a chamfering process. In other words, the ridges E, F, J and K have obtuse angles. In particular, at the ridge portions H and/or vertex portions G, i.e., at the ridges E, F, J and/or K, in the foregoing thermoelectric conversion device main body 1, the film 8 can be easily formed to a uniform thickness similar to that of the other plane portion.

Accordingly, in the foregoing thermoelectric conversion device 10 under a high temperature atmosphere, for example, even if an atmospheric gas is an oxidizing gas such as air by which the thermoelectric conversion device main body is likely to oxidize, or even if an atmospheric gas is a reducing gas such as an inert gas by which the reduction of the thermoelectric conversion device main body is likely to occur, the diffusion of the gas via the film is reduced, thus enabling the reduction of characteristic degradation in the thermoelectric conversion device.

In the present embodiment, the numbers of the ridge portions H and vertex portions G are not limited, and the invention may be carried out even if right-angled or acute-angled ridges partially remain. From the viewpoint of resistance to characteristic degradation, it is preferable that a larger number of the ridge portions H and/or vertex portions G are provided and no right-angled or acute-angled ridge exists.

Next, a method for producing the foregoing thermoelectric conversion device will be briefly described.

As a method for C-chamfering the thermoelectric conversion device main body 1, a conventional method for processing a metal or ceramic material using a diamond cutter, a water-resistant paper, an abrasive cloth or the like may be used.

A method for forming the film 8 is not particularly limited, and various methods such as sputtering and coating may be utilized.

In the sputtering, sputtering may be performed, for example, using a film material as a target.

Furthermore, in the coating, a coating solution including a film precursor, for example, may be applied to the surface of the thermoelectric conversion device main body 1, and then the film may be formed on the surface by performing processes such as drying, and firing.

As the coating solution, for example, a solution including a film precursor and a solvent for dissolving or dispersing this precursor may be used. As the film precursor, a silica precursor such as a silicon compound having a siloxane bond and/or polysilazane, an alumina precursor such as aluminum alkoxide, or a silicon carbide precursor such as polycarbosilane or polyvinylsilane may be used.

As the solvent, for example, water and alcohols such as methanol and ethanol may be used, and one of these solvents may be used singly or a combination with another or more may be used.

For the coating, spraying, dip-coating or the like may be used. Firing conditions require the firing to be performed at 200°C for one hour in the air, for example.

A mask is formed in advance over the region of the exposed portion 1s before the formation of the film, or part of the film is removed after the formation of the film 8, thereby allowing the exposed portion 1s to be formed as illustrated in FIG. 1 and FIGS. 3 and 4.

The thermoelectric conversion device main body 1 may have the ridge portions H and/or vertex portions G which have been C-chamfered, or may alternatively have the foregoing form without being subjected to chamfering; for example, the thermoelectric conversion device main body may be produced without being chamfered by preparing a mold capable of forming the ridge portions H or vertex portions G which are in the chamfered state, by forming a green body including a thermoelectric conversion device material with the use of this mold, and then by using a method for firing the green body.

### Second Embodiment

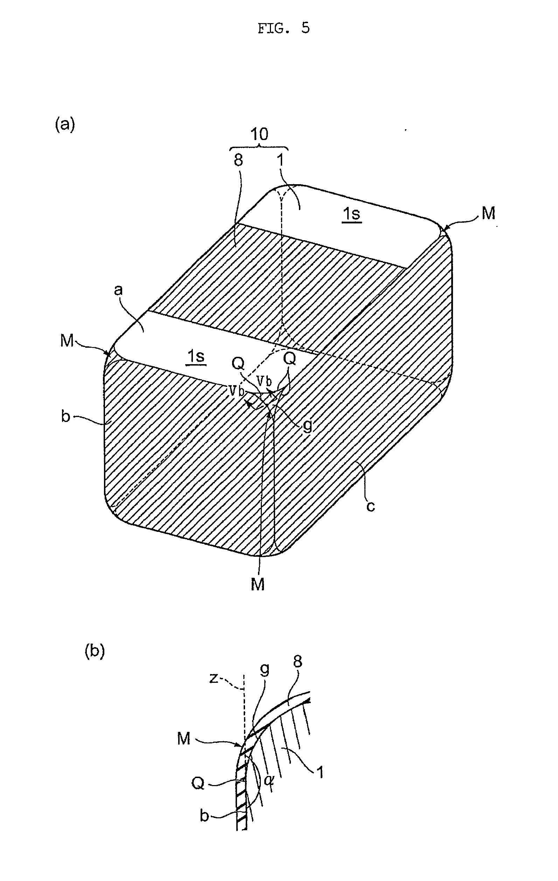

Next, thermoelectric devices according to a second embodiment will be described. FIG. 5(a) illustrates a perspective view of one example of the thermoelectric conversion device 10 according to the second embodiment of the present invention. The thermoelectric conversion device 10 has vertex portions M each formed by an outwardly convex curved surface g, and is almost in the shape of rectangular parallelepiped. These vertex portions M are in a state where each vertex A of the rectangular parallelepiped of the thermoelectric conversion device 10 in FIG. 2 is R-chamfered, i.e., chamfered by an outwardly convex curved surface such as a spherical surface. At each vertex portion M, planes a and b, the planes a and c, and the planes b and c, surrounding the vertex portion M, are connected via the curved surface g. At these connected portions, ridges Q are formed.

In FIG. 5(b), there is illustrated a partial cross-sectional view taken perpendicularly to the ridge Q along a dotted line Vb-Vb of the thermoelectric conversion device 10. In a cross section taken perpendicularly to the ridge Q, an angle α created by the plane b and the curved surface g at the ridge Q is far greater than 90°, and is preferably about 180°C. In this case, the angle α created by the curved surface g and the plane b can be defined as the angle α created by: a tangent Z to the ridge Q of the curved surface g; and the plane b.

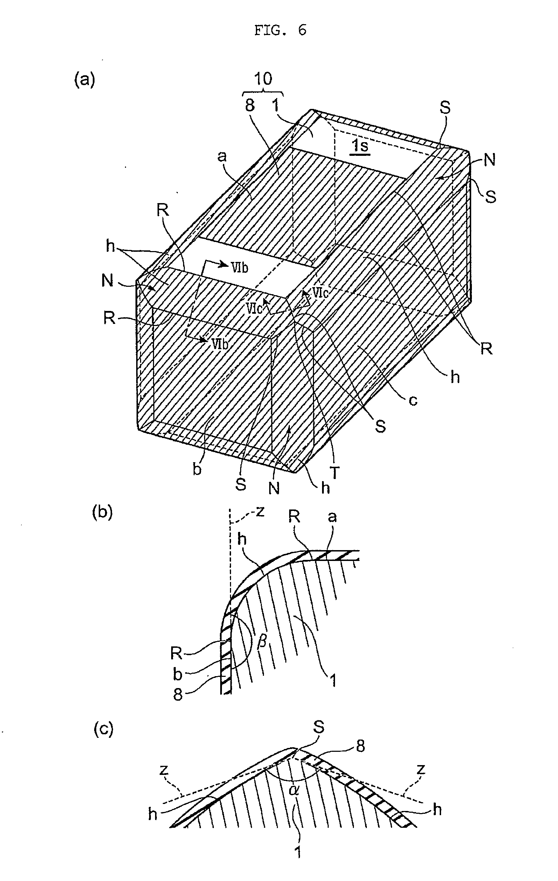

FIG. 6(a) illustrates a perspective view of another example of a thermoelectric conversion device according to the second embodiment of the present invention. The thermoelectric conversion device 10 has ridge portions N each formed by an outwardly convex cylindrical curved surface h, and is almost in the shape of rectangular parallelepiped. The thermoelectric conversion device 10 in FIG. 6(a) is in a state where each ridge B of the thermoelectric conversion device 10 in FIG. 2 is R-chamfered, i.e., chamfered by a curved surface such as a cylindrical surface, and a new vertex T is formed instead of each vertex A. Around each vertex T, a ridge S is formed as a line along which the ridge portions N meet. The ridge portions N form the curved surfaces h each surrounded by: two ridges R parallel to the original ridge B; and the four ridges S.

In FIG. 6(b), there is illustrated a partial cross-sectional view taken perpendicularly to the axial direction of the ridge portion N along a dotted line VIb-VIb of the thermoelectric conversion device 10. In a cross section taken perpendicularly to the axial direction of the ridge portion N, two planes a and b are connected via the curved surface h by which the ridge portion N is formed. The cross-sectional shape of the ridge portion N is an outwardly convex curved surface, and is preferably a cylindrical surface. Accordingly, in a cross section taken perpendicularly to the ridge R, an angle β created by the plane b and the curved surface h at the ridge R is far greater than 90°, and is preferably about 180°.

Furthermore, in FIG. 6(c), there is illustrated a partial cross-sectional view taken perpendicularly to the ridge S along a dotted line VIc-VIc of the thermoelectric conversion device 10. The ridge S is a line along which the ridge portions N serving as the two curved surfaces are brought into contact with each other, and are gently connected. Accordingly, in a cross section taken perpendicularly to the ridge S, an angle α created by the curved surface h and the curved surface h at the ridge S is far greater than 90°, and is preferably about 180°. In this case, the angle α created by the curved surface h and the curved surface h can be defined as the angle α created by the tangents Z to the ridge S of the respective curved surfaces h.

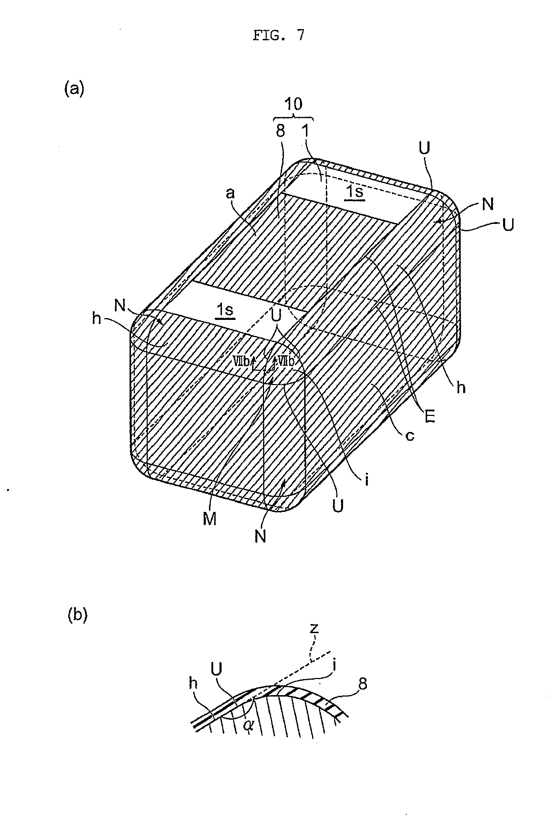

FIG. 7 (a) illustrates a perspective view of still another example of a thermoelectric conversion device according to the second embodiment of the present invention. The thermoelectric conversion device 10 is in a state where the vertexes T in FIG. 6 (a) are further R-chamfered, and the ridge portions N are connected via a vertex portion M that is an outwardly convex curved surface i, e.g., a spherical surface. At the connected portions, ridges U are formed.

In FIG. 7(b), there is illustrated a partial cross-sectional view taken perpendicularly to the ridge U along a dotted line VIIb-VIIb of the thermoelectric conversion device 10. The ridge U is a line along which the ridge portion N serving as the curved surface h and the vertex portion M serving as the curved surface i are brought into contact with each other. Accordingly, in a cross section taken perpendicularly to the ridge U, an angle α created by the curved surface h and the curved surface i at the ridge U is far greater than 90°, and is preferably about 180°.

As for the second embodiment according to the present invention, materials for the thermoelectric conversion device main body 1 and the film 8, production methods thereof and the like are similar to those of the first embodiment. In particular, as a method for R-chamfering the thermoelectric conversion device main body 1, a conventional processing method such as polishing using a rotary barrel or grinding may be used.

Moreover, the second embodiment is similar to the first embodiment in that although the thermoelectric conversion device main body 1 may have the ridge portions H and/or vertex portions G, which have been R-chamfered, the thermoelectric conversion device main body 1 may alternatively be produced without being chamfered.

Besides, in the present embodiment, the numbers of the ridge portions N and vertex portions M are not limited, and the invention may be carried out even if right-angled or acute-angled ridges partially remain. From the viewpoint of resistance to characteristic degradation, it is preferable that a larger number of the ridge portions N and/or vertex portions M are provided and no right-angled or acute-angled ridge exists.

In the foregoing thermoelectric conversion device, the thermoelectric device main body 1 has the ridge portions N and/or vertex portions M at which the ridges B and/or vertexes A have been subjected to a chamfering process. In other words, the ridges Q, R, S and U have obtuse angles. In particular, at the ridge portions N and/or vertex portions M, i.e., at the ridges Q, R, S and/or U, in the foregoing thermoelectric conversion device main body 1, the film can be easily formed to a uniform thickness similar to that of the other plane portion.

Accordingly, in the foregoing thermoelectric conversion device 10 under a high temperature atmosphere, for example, even if an atmospheric gas is an oxidizing gas such as air by which the thermoelectric conversion device main body is likely to oxidize, or even if an atmospheric gas is a reducing gas such as an inert gas by which the reduction of the thermoelectric conversion device main body is likely to occur, the diffusion of the gas via the film is reduced, thus enabling the reduction of characteristic degradation in the thermoelectric conversion device.

### Third Embodiment

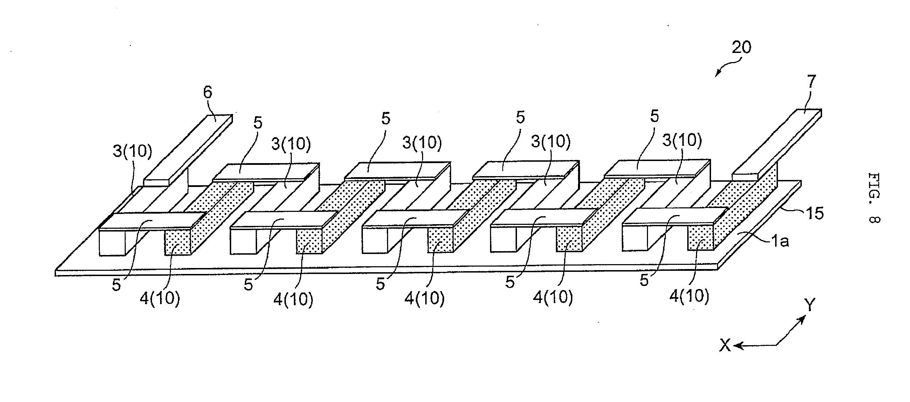

A thermoelectric conversion module, in which thermoelectric conversion devices formed as described above are used, will be described with reference to FIG. 8. A thermoelectric conversion module 20 mainly includes a substrate 15, p-type thermoelectric conversion devices 3, n-type thermoelectric conversion devices 4, electrodes 5, and input/output electrodes 6 and 7. Specifically, in the thermoelectric conversion module 20 of the present embodiment, a plurality of the p-type thermoelectric devices 3 and a plurality of the n-type thermoelectric devices 4 are provided over one surface la of the above-mentioned substrate 15 so that the longitudinal direction (y direction) of the plurality of p-type thermoelectric devices 3 and the plurality of n-type thermoelectric devices 4 extends along the widthwise direction (y direction) of the substrate 15 and the devices are separated from each other in the longitudinal direction (x direction) of the substrate 15. Further, each of the thermoelectric conversion devices 3 and 4 is the thermoelectric conversion device 10 according to the first embodiment or the second embodiment.

The foregoing thermoelectric conversion module is capable of sufficiently reducing the degradation of thermoelectric conversion devices caused by oxidation or reduction even when the environment of usage is an oxidizing atmosphere or reducing atmosphere at high temperature.

Especially the thermoelectric conversion devices have very low reactivity to oxidation or reduction, and thus can be suitably applied to a thermoelectric conversion module and the like operated in the high temperature air or in a corrosive gas atmosphere in particular.

The present invention is not limited to the above-described embodiments, and various modified forms may be provided. For example, there may be provided a form in which a ridge portion and a vertex portion, which are in C-chamfered states, are combined with a ridge portion and a vertex portion, which are in R-chamfered states. Furthermore, the thermoelectric conversion device does not have to be formed into a rectangular parallelepiped shape, and may be formed into a disk-like shape or the like.

### EXAMPLES

Examples and comparative examples in the present invention will be specifically described, but the present invention is not limited to these examples.

### Example 1

A sintered body of a titania-based thermoelectric material (NbₓTiᵢ₋ₓO₃, where X=0.5) was prepared, and a cube of 4 mm per side was cut out with a diamond cutter, thereby providing a thermoelectric conversion device main body. Subsequently, all vertexes and ridges of this cube were R-chamfered using a sand paper, thus performing an operation for removing sharp edges.

Then, the chamfered thermoelectric conversion device main body was coated with a silica coating agent ("EPL-X-050" manufactured by Exousia Inc.) by dip-coating, and was subsequently fired in an air atmosphere at 300°C for 30 minutes to form a film of 0.5µm, thus obtaining a thermoelectric conversion device.

### Example 2

A thermoelectric conversion device was obtained similarly to Example 1 except that a film of 200µm was formed by using a silica-alumina coating agent ("Betack#160CC" manufactured by Telnik Industrial Co. , Ltd.) as a coating agent, and performing firing at 200°C for one hour.

### Example 3

A thermoelectric conversion device was obtained similarly to Example 1 except that a film of 100µm was formed by using a silica coating agent ("SPLW-Y" manufactured by Ceramic Coat Co., Ltd.) as a coating agent, and performing firing at 200°C for one hour.

### Example 4

A thermoelectric conversion device was obtained similarly to Example 1 except that a film of 50µm was formed by using a silicon carbide coating agent ("SPG26M" manufactured by Ceramic Coat Co., Ltd.) as a coating agent, and performing firing at 200°C for one hour.

### Comparative Examples 1 to 4

Thermoelectric conversion devices according to Comparative Examples 1 to 4 were obtained similarly to Examples 1 to 4, respectively, except that vertexes and ridges were not chamfered.

### Comparative Example 5

A thermoelectric conversion device according to Comparative Example 5 was obtained similarly to Example 1 except that no film was formed.

### Comparative Example 6

A thermoelectric conversion device according to Comparative Example 6 was obtained similarly to Comparative Example 1 except that no film was formed.

### Evaluations:

For the respective thermoelectric conversion devices according to Examples 1 to 4 and Comparative Examples 1 to 6, measurements were made on initial resistance values in the room temperature air; then, the devices were heated and held at 700°C for two hours in the air, and the temperature was subsequently reduced to room temperature to make measurements on resistance values. As for the thermoelectric conversion device according to Example 1, a measurement was also made on a resistance value when the device was heated and held at 700°C for two hours in an inert atmosphere (nitrogen) and the temperature was subsequently reduced to room temperature.

The measurements of the resistance values were made by attaching a four-terminal electrode using a silver paste after polishing and removing the film on two opposed planes using a sand paper.

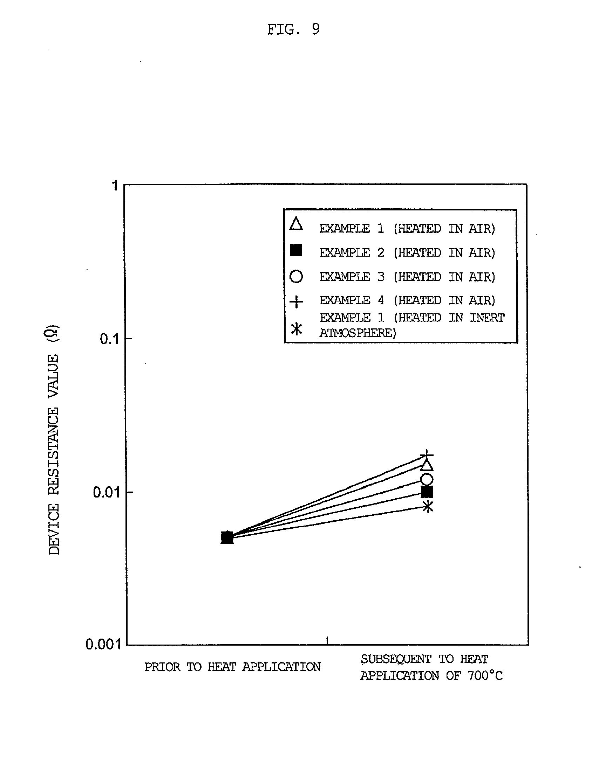

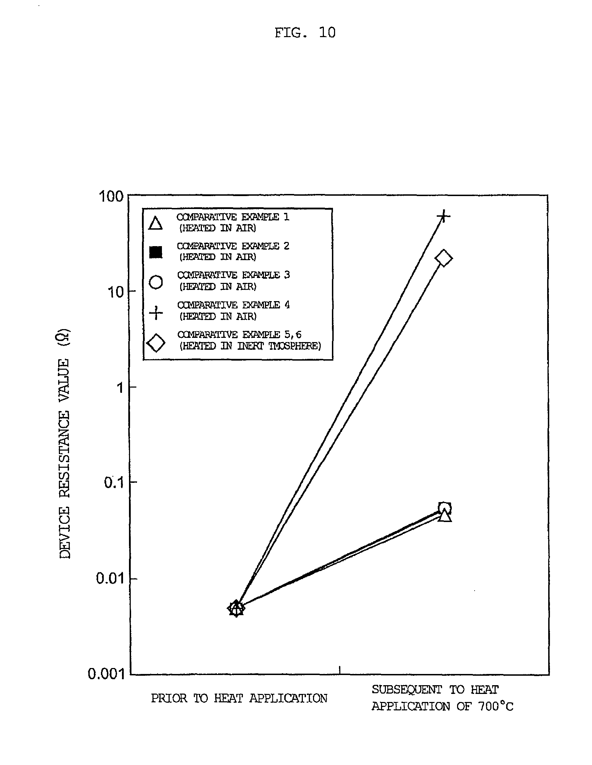

FIG. 9 illustrates resistance values of the chamfered thermoelectric conversion devices according to Examples 1 to 4 prior to and subsequent to heat application in the air; and resistance values of the thermoelectric conversion device according to Example 1 prior to and subsequent to heat application in an inert atmosphere. Furthermore, FIG. 10 illustrates resistance values of the thermoelectric conversion devices according to Comparative Examples 1 to 6 prior to and subsequent to heat application in the air.

The thermoelectric conversion devices according to Examples 1 to 4 were able to maintain the resistance values at sufficiently low levels even after the heat application in the air. On the other hand, in Comparative Examples 1 to 6, the resistance values were considerably increased after the heat application in the air.

### INDUSTRIAL APPLICABILITY

According to the present invention, there are provided thermoelectric conversion devices and production methods thereof, which are capable of reducing the degradation of characteristics in a high temperature environment.

## Claims

1. A thermoelectric conversion device comprising:
a thermoelectric conversion device main body having a ridge portion and/or a vertex portion at which a ridge and/or a vertex have/has been subjected to a chamfering process; and
a film covering a surface of the thermoelectric conversion device main body, including the ridge portion and/or the vertex portion thereof.

2. A thermoelectric conversion device comprising:
a thermoelectric conversion device main body having a ridge at which two faces meet, and having an angle created by the two faces at the ridge in a cross section taken perpendicularly to the ridge, the angle being an obtuse angle; and
a film covering a surface of the thermoelectric conversion device main body, including the ridge.

3. The thermoelectric conversion device according to either claim 1 or 2, wherein the film is an oxidation preventing film.

4. The thermoelectric conversion device according to any one of claims 1 to 3, wherein a main material for the film is at least one of silica, alumina and silicon carbide.

5. The thermoelectric conversion device according to any one of claims 1 to 4, wherein the film has a thickness of 0.01µm to 1mm.

6. The thermoelectric conversion device according to any one of claims 1 to 4, wherein the film has a thickness of 0.1µm to 300µm.

7. A method for producing a thermoelectric conversion device, comprising the steps of:
performing a chamfering process on a ridge and/or a vertex of a thermoelectric conversion device main body; and
forming a film on a surface of the thermoelectric conversion device main body, including a ridge portion and/or a vertex portion on which the chamfering process has been performed.

8. A method for producing a thermoelectric conversion device, comprising the steps of:
preparing a thermoelectric conversion device main body having a ridge at which two faces meet, and having an angle created by the two faces at the ridge in a cross section taken perpendicularly to the ridge, the angle being an obtuse angle; and
forming a film on a surface of the thermoelectric conversion device, including the ridge.
